# EUROPEAN PATENT SPECIFICATION

(11) **EP 2 566 312 B1**
(45) Date of publication and mention of the grant of the patent: **05.04.2017**
(21) Application number: 12174816.4
(22) Date of filing: 03.07.2012
(51) Int. Cl.: H05K 9/00

(54) **Board level electromagnetic interference (EMI) shields including releasably attached/detachable pickup members**
Elektromagnetische Interferenz (EMI) Schilde auf Plattenebene mit entfernbar angebrachten/anbringbaren Aufnahmeelementen
Protection contre les interférences électromagnétiques (EMI) au niveau de la carte comprenant des éléments de capture fixés de manière libérable/détachable

(30) Priority: 03.08.2011 US 201113197459
(43) Date of publication of application: 06.03.2013
(73) Proprietor: Laird Technologies, Inc., Saint Louis, MO 63045 (US)
(72) Inventor: Crotty, Paul W., East Stroudsburg, PA Pennsylvania 18301 (US)
(74) Representative: Awapatent AB

(56) References cited:
- EP-A1- 2 031 950
- JP-A- 2006 049 710
- JP-A- 2007 266 024
- JP-A- 2008 034 713

## Description

### CROSS-REFERENCE TO RELATED APPLICATION

This application claims the benefit and priority of United States Patent Application 13/197,459 filed August 3, 2011.

### FIELD

The present disclosure generally relates to shields suitable for shielding components on a printed circuit board from electromagnetic interference (EMI)/radio frequency interference (RFI).

### BACKGROUND

This section provides background information related to the present disclosure which is not necessarily prior art.

Electronic equipment often generates electromagnetic signals in one portion of the electronic equipment that may radiate to and interfere with another portion of the electronic equipment. This electromagnetic interference (EMI) can cause degradation or complete loss of important signals, thereby rendering the electronic equipment inefficient or inoperable. To reduce the adverse effects of EMI, electrically conducting (and sometimes magnetically conducting) material is interposed between the two portions of the electronic circuitry for absorbing and/or reflecting EMI energy. This shielding may take the form of a wall or a complete enclosure and may be placed around the portion of the electronic circuit generating the electromagnetic signal and/or may be placed around the portion of the electronic circuit that is susceptible to the electromagnetic signal. For example, electronic circuits or components of a printed circuit board (PCB) are often enclosed with shields to localize EMI within its source, and to insulate other devices proximal to the EMI source.

As used herein, the term electromagnetic interference (EMI) should be considered to generally include and refer to both electromagnetic interference (EMI) and radio frequency interference (RFI) emissions, and the term "electromagnetic" should be considered to generally include and refer to both electromagnetic and radio frequency from external sources and internal sources. Accordingly, the term shielding (as used herein) generally includes and refers to both EMI shielding and RFI shielding, for example, to prevent (or at least reduce) ingress and egress of EMI and RFI relative to a housing or other enclosure in which electronic equipment is disposed.

### SUMMARY

This section provides a general summary of the disclosure, and is not a comprehensive disclosure of its full scope or all of its features.

Disclosed herein are exemplary embodiments of shielding apparatus including a frame and a releasably attached or detachable pickup member. Other aspects of the present disclosure relate to methods of installing a shielding apparatus to a substrate.

An exemplary embodiment of a shielding apparatus generally includes a frame configured for installation to a substrate generally about one or more components on the substrate. A pickup member is integrally formed with and releasably attachable to the frame. The pickup member is configured to allow the pickup member and the frame to be picked up. The pickup member is detachable and completely separable from the frame.

Another exemplary embodiment of a shielding apparatus generally includes a frame having sidewalls and a pickup member. An interlock is integrally defined by the frame and pickup member. The interlock releasably attached the pickup member to the frame. The pickup member extends between at least a pair of the sidewalls of the frame when releasably attached to the frame by the interlock. The pickup member detachable and completely separable from the frame upon disengagement of the interlock.

Another exemplary embodiment includes a frame of a shielding assembly, which is configured for installation to a substrate generally about one or more components on the substrate. The frame includes a first interlocking portion integral to the frame. The first interlocking portion is releasably attachable and detachable from a second interlocking portion of a pickup member integrally formed with the frame. The releasable attachment of the first and second interlocking portions allows the frame to be picked up by the pickup member and placed on the substrate. The first interlocking member is detachable from the second interlocking portion such that the pickup member is completely separable from the frame which may thus remain installed on the substrate without the pickup member.

In another exemplary embodiment, a method generally includes detaching a pickup member releasably attached to a frame integrally formed with the pickup member. The method may also include removing the pickup member from the frame.

Further areas of applicability will become apparent from the description provided herein. The description and specific examples in this summary are intended for purposes of illustration only and are not intended to limit the scope of the present disclosure.

### DRAWINGS

The drawings described herein are for illustrative purposes only of selected embodiments and not all possible implementations, and are not intended to limit the scope of the present disclosure.
FIG. 1 is an upper exploded perspective view of an EMI shielding assembly including a frame, a pickup bridge, and a cover according to an exemplary embodiment;
FIG. 2 is a lower exploded perspective of the EMI shielding assembly shown in FIG. 1;
FIG. 3 is an upper perspective view illustrating the pickup bridge releasably attached to the frame shown in FIG. 1;
FIG. 4 is an enlarged perspective view of the portion designated A in FIG. 3, and illustrating the releasable interlock between the pickup bridge and the frame;
FIG. 5 is a lower perspective view illustrating the pickup bridge releasably attached to the frame shown in FIG. 3;
FIG. 6 is an upper perspective view illustrating a pickup bridge releasably attached to a frame according to another exemplary embodiment;
FIG. 7 is an enlarged perspective view of the portion designated B in FIG. 6, and illustrating the releasable interlock between the pickup bridge and the frame;
FIG. 8 is a lower perspective view illustrating the pickup bridge releasably attached to the frame shown in FIG. 6;
FIG. 9 is an upper perspective view illustrating the pickup bridge shown in FIG. 6 after removal or detachment from the frame;
FIG. 10 is a lower perspective view illustrating the detached pickup bridge and frame shown in FIG. 9; and
FIG. 11 is an upper perspective view illustrating a pickup bridge releasably attached to a frame according to another exemplary embodiment.

### DETAILED DESCRIPTION

Example embodiments will now be described more fully with reference to the accompanying drawings.

Board level shielding (BLS) for electromagnetic compatibility (EMC) purposes is often accomplished by using a two piece shielding assembly comprised of a frame and a cover. For such two piece BLS solutions, the frame is typically placed onto a printed circuit board (PCB) by automated means in preparation for solder reflow. This may be done by pick and place equipment (e.g., suction nozzle, grippers, etc.) that grasp corners of the frame or a grasp support member extending between two or more sidewalls of the frame, which has an expanded pickup area to allow for suction or mechanical pickup features. The grasp support member is to facilitate the manufacturing assembly process and is not a functional part of the assembled two-piece shielding assembly.

In many cases, there are post reflow operations, such as inspection that require the grasp support member to be removed for greater access to the PCB components within the BLS footprint. For example, after a BLS frame is secured to a PCB, the grasp support member is often removed for repair work or post solder reflow inspection. The inventor hereof has recognized that there are inherent disadvantages with those existing shielding assemblies in which the grasp support member removal method includes manually cutting, snipping, or otherwise severing necked down areas of the grasp support member near the frame walls or include the use of scored features that are severed by employing a twisting motion to separate the grasp support member from the frame. As recognized by the inventor hereof, such removal methods have inherent disadvantages, such as deformation of the frame which may affect the fit of the cover during final assembly and excessive labor and/or inconsistent effort to remove the grasp support member.

Accordingly, the inventor has developed and discloses herein exemplary embodiments of shielding assemblies that include a pickup member, bridge, cross member, or grasp support member releasably attached to a frame. As disclosed herein, the retention of the pick and place bridge to the frame may be accomplished by a releasable interlock between the bridge and sidewalls of the frame. The interlock may also allow the bridge to be reattached to the frame though reattachment is not required and is unlikely to occur after the frame is installed to a PCB. The BLS frame to which the bridge is releasably attached may have a flange surface around the top perimeter or it may be flangeless (no lip) so as to provide greater access to the components within the BLS frame footprint.

Advantageously, the releasable attachment of the bridge to the frame in exemplary embodiments disclosed herein creates a simple, reliable and repeatable means to remove the pick and place bridge of a BLS frame, without causing any deformation to the frame component that remains on (e.g., soldered to, etc.) the PCB. The releasable attachment provides a secure enough attachment for the bridge to withstand part handling by pick and place automation, while also allowing the bridge to be easily removed after the frame is mounted to (e.g., soldered, etc.) the PCB.

In comparison to those existing grasp support members that must be laboriously cut, snipped, or twisted off a frame, the inventor's releasably attached pickup bridges provide a removal that is more reliable, easier, and/or more repeatable whether by hand or by automated means. The releasably attached pickup bridge may be removed via the same pick and place equipment that placed the frame on the PCB, though different automated means may be used as well to remove the releasably attached bridge.

The releasable attachment of the bridge to the frame may also not require any additional room for installation. For example, the releasable interlock between the bridge and the frame sidewalls may remain within the perimeter or footprint of the frame as the interlock may be configured to be contained within (and not extend outwardly beyond) the same plane that contains the corresponding frame's sidewalls. This, in turn, allows for a smaller installation space as compared to an attachment outside the frame's footprint, which would require additional room for installation of the BLS frame.

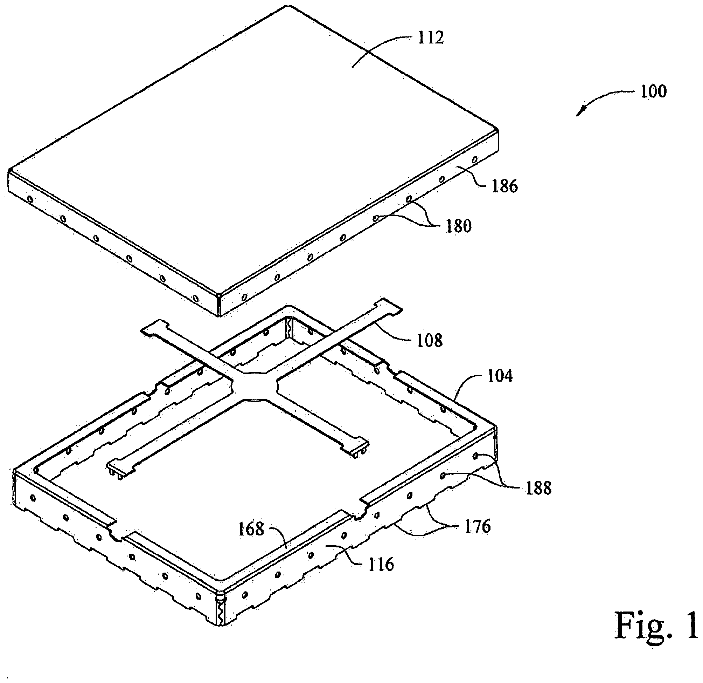

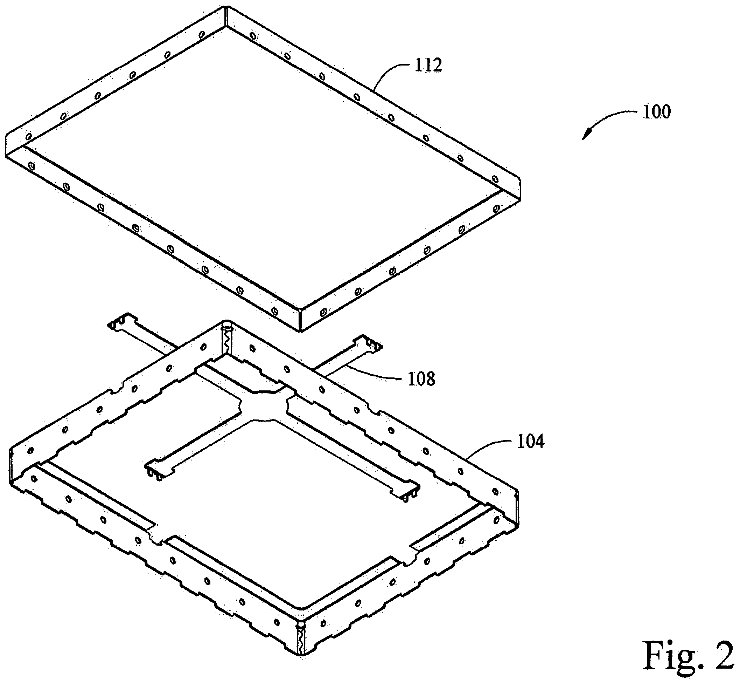

Referring now to the drawings, FIGS. 1 and 2 illustrate an exemplary embodiment of a shielding apparatus, assembly, or shield 100 embodying one or more aspects of the present disclosure. The shielding apparatus 100 may be installed to a printed circuit board (a PCB, and broadly a substrate) and is suitable for use in providing electromagnetic interference (EMI) shielding to one or more components mounted on the PCB.

The shielding assembly 100 generally includes a frame 104 (or first shield member) and a releasably attached pickup member 108 (bridge, cross member, grasp support member, or pickup) 108. The pickup member or bridge 108 is configured such that the bridge 108 (and frame 104 to which it is releasably attaché) may be picked up and placed on a PCB by a suction nozzle, gripper, or head associated with pick-and-place equipment. The EMI shielding assembly also includes a lid or cover 112 (or second shield member) attachable to the frame 104 for covering the open top of the frame 104.

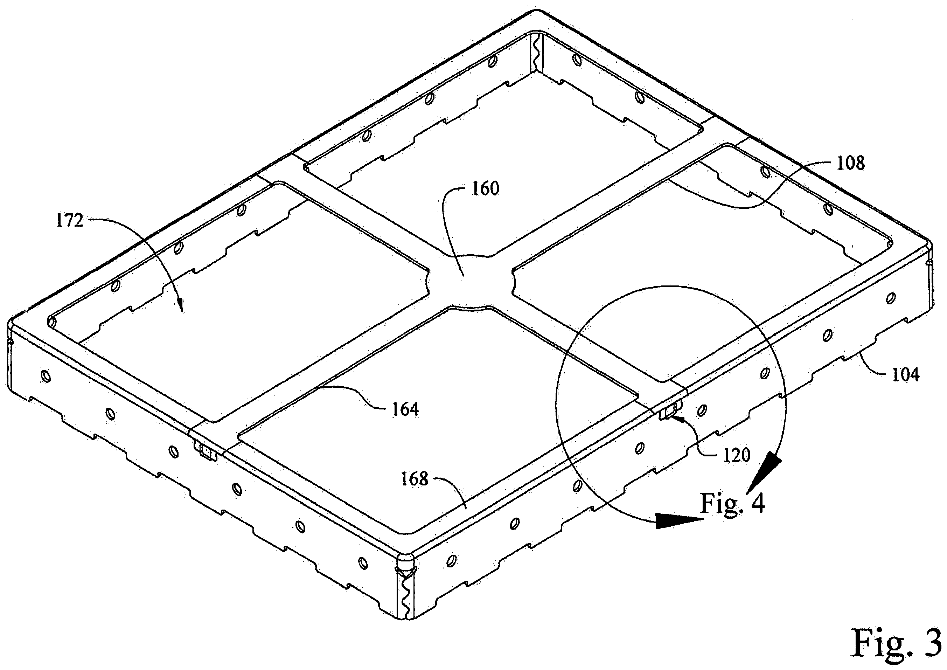

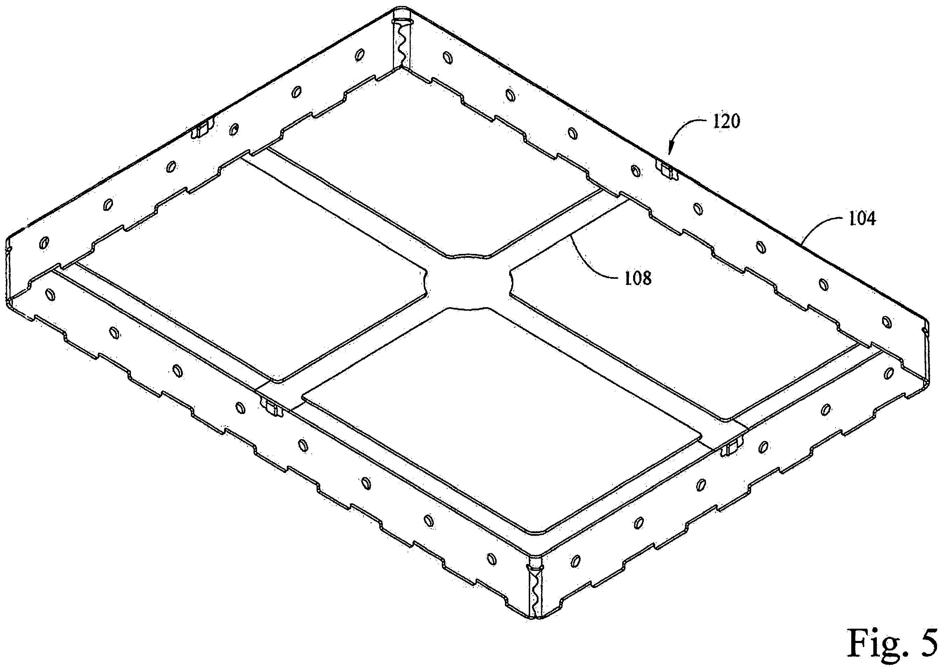

As shown in FIGS. 3 through 5, the pickup bridge 108 is releasably attached to the frame 104 such that the bridge 108 extends between the frame's four sidewalls 116. The bridge 108 spans across the open top of the frame 104.

In this illustrated embodiment, the bridge 108 is releasably attached to the frame 104 by a mechanism or interlock 120 integrally formed or defined by portions of the bridge 108 and frame 104. The mechanism or interlock 120 is configured to allow the bridge 108 to be readily detached or removed from the frame 104 without deforming the frame 104. But the mechanism or interlock 120 provides a secure enough attachment such that the frame 104 does not detach from the bridge 108 when the bridge 108 is picked up by pick and place automation.

The amount of force needed to release the bridge 108 from the frame 104 may vary depending on the particular application, such as the particular size and mass of the frame. For example, the interlocking geometry may be configured (e.g., with a larger offset in the interlocking geometry, made from a more rigid and less resilient material, etc.) such that a higher force is needed to detach the bridge 108 from the frame 104 when the frame 104 is larger and has greater mass. Configuring the interlock 120 such that a higher force is needed for detachment or removal would help prevent the larger, heavier frame 104 from being inadvertently detached from the bridge 108 when being picked up and placed on a shield manually or automatically (e.g., via pick and place equipment, etc.).

The interlock 120 in this illustrated embodiment may also allow for reattachment of the bridge 108 to the frame 104. But reattachment is not required and is unlikely to occur after the frame 104 is installed to a PCB. The frame 104 and bridge 108 may be advantageously made from a single sheet of material as disclosed herein.

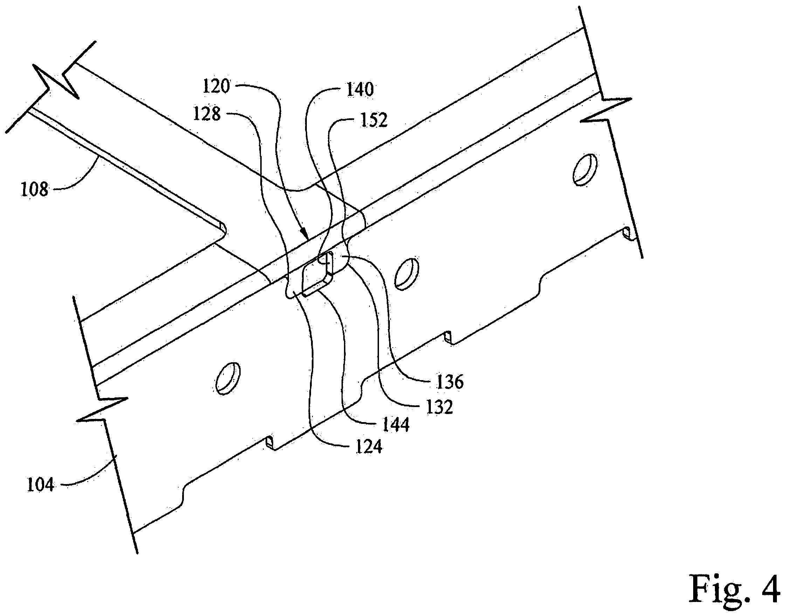

With continued reference to FIG. 4, the mechanism 120 includes first and second interlocking members 124 and 128. The interlocking members 124 and 128 are releasably or detachably engaged with one another, such that the bridge 108 is also releasably or detachably engaged to the frame 104. The interlocking members 124 are integrally defined by and part of the bridge 108. The interlocking members 124 depend downwardly from the bridge 108. The interlocking members 124 include protrusions 132 having a tapered side surface portion 136 and another side surface 140 defining a portion of the opening 144.

The interlocking members 128 are integrally defined by and part of the frame 104. The interlocking members 128 extend generally upwardly toward the bridge 108. The interlocking members 128 comprise cutouts, voids, etc. extending generally inwardly and downwardly into the sidewalls 116 of the frame 104. The side surface portions 148 of each cutout are complementary in shape to tapered side surface portion 136 of the corresponding interlocking members 124. When the bridge's interlocking members 124 are inserted into and engaged with the corresponding interlocking members 128 of the frame 104, the portions 148 of the frame's interlocking members 128 respectively engage (e.g., frictionally retain, etc.) the tapered portions 136 of the corresponding interlocking members 124 of the bridge 108. Also shown in FIG. 4, the openings 144 may include portions defined by side surface portions of each cutout.

The material forming the bridge's interlocking members 124 may be sufficiently resilient such that the bridge's interlocking members 124 may essentially operate as outwardly biased resilient tines that are frictionally engaged generally under the frame's interlocking members 128. The tapered portions 136 of the bridge's interlocking members 124 may be frictionally engaged under the portions 148 of the frame's interlocking members 128, whereby the bridge 108 is releasably attached to the frame 104.

The bridge's interlocking members 124 may be formed from a sufficiently resilient or compliant material to allow the bridge's interlocking members 124 to move inwardly towards each other and into the opening 144 (FIG. 4) when the bridge 108 is being detached from the frame 104. For example, the interlocking members 124 may move or flex inwardly into the opening 144 while generally remaining within the same plane having the corresponding frame sidewall 116 as the bridge 108 is being lifted off the frame 104.

As the bridge 108 is moved upwardly away from the frame 104, the bridge's interlocking members 124 may contact cam surfaces 152 of the frame's interlocking members 128. The interlocking members 124 may be generally resilient in nature such that contact with the camming surfaces 152 causes the interlocking members 124 to flex inwardly into the opening 144. After passing beyond the frame's cam surfaces 152 (or the portions 156 of the cam surfaces 152 that impinge the farthest inwardly into the opening 144), the bridge 108 is able to be completely removed from the frame 104.

As noted above, the bridge 108 may also be reattached to the frame 104 via the interlock 118. To reattach the bridge 108, the bridge 108 is moved downward onto the frame's sidewalls 104 such that the bridge's interlocking members 124 contact the cam surfaces 152 of the frame's interlocking members 128. This contact causes the bridge's interlocking members 124 to flex inwardly into the opening 144. But after passing beyond the cam surfaces 152 (or the portions 156 of the cam surfaces 152 that impinge the farthest inwardly into the opening 144), the bridge's interlocking members 124 may then snap outwardly to thereby frictionally engage the tapered portions 136 of the bridge's interlocking members 124 with the portions 148 of the frame's interlocking members 128. The material forming the bridge's interlocking members 124 may be sufficiently resilient such that the bridge's interlocking members 124 may essentially operate as outwardly biased resilient tines that snap outwardly for frictional engagement generally under the frame's interlocking members 128. In this exemplary snap fitting manner, the bridge 108 may thus be reattached to the frame 104.

In the particular illustrated embodiment, the frame 104 and bridge 108 cooperatively define one interlock 120 along each side of the frame 104. The frame 104 and bridge 108 cooperatively define one opening 144 and a corresponding pair of the interlocking members 124, 128 along each side of the opening 144. Accordingly, the releasable attachment or interlocking mechanism between the frame 104 and the bridge 108 thus includes interlocking features along each shorter side of the frame 104.

The configuration (e.g., shape, size, material used, etc.), location, and particular number of openings 144 and interlocking members 124, 128 may be varied depending, for example, on the particular installation. For example, the openings 144 in the illustrated embodiment are generally rectangular. Alternatively, the openings may in other shapes, such as circular, rectangular, square, triangle, etc. Alternative configurations (e.g., shapes, sizes, without openings, etc.) may also be used for the interlocking members 124 and 128, and aspects of the present disclosure are not limited to the particular configuration of the interlock 120 shown in FIG. 4. For example, another exemplary embodiment may include an interlock having a dovetail like features without any opening where the dovetail like features release or detach by moving inwardly relative to the frame perimeter or sidewall. Alternative embodiments can include other means for releasably attaching or detachably engaging the bridge 108 to the frame 104.

The bridge 108 also includes a pick-up area 160. The pickup area 160 is configured (e.g., sized, shaped, located, etc.) to enable the bridge 108 to be picked up by a head associated with pick-and-place equipment, such as by a suction nozzle, gripper, or other pickup features. For example, the pickup area may be configured to allow the frame 104 and releasably attached bridge 108 to be picked up, moved, and placed onto a PCB with pick-and-place equipment *(e.g.,* vacuum pick-and-place equipment, etc.). The pick-up area 160 may be configured for use as a pick-up area that may be gripped or to which suction may be applied by the pick-and-place equipment for handling during original installation of the frame 104 to a PCB. The pick-up area 160 may be generally centrally located, etc. to allow for balanced manipulation of the frame 104 during handling. In other exemplary embodiments, a frame 104 may also include tabs at corners and/or along side edges for use as additional pick-up surfaces.

In this illustrated embodiment, the pickup area 160 of the bridge 108 is centrally located, generally flat, and circular. In addition, the bridge 108 includes four arms or cross braces 164. Each arm 164 extends outwardly from about a middle of a corresponding one of the sidewalls 116 to the pickup area or central hub 160. As shown in FIG. 3, the interlocking members 124 downwardly depend from the end portions of the arms 164.

The arms 164 are equally spaced apart (e.g., 90 degrees apart, etc.) about the perimeter of the pickup area 160. Each arm 164 is releasably attached to a corresponding sidewall 116 of the frame 104 via interlocking members 124, 128 as explained above. Moreover, each arm 164 is generally perpendicular with the corresponding sidewall 116 to which it is releasably attached, such that the bridge 108 has a generally cross shape with the circular hub 160 in the middle. Accordingly, the bridge 108 and the frame's inwardly extending flange, rim, or lip 168 define four openings or windows 172 (FIG. 3). In other exemplary embodiments, there may be more or less openings 172 in different sizes and/or shapes than what is illustrated in the figures.

In some embodiments, the arms 164 of the bridge 108 interconnect the sidewalls 116 and may provide stiffening support to the frame 104, for example, to resist deformation (*e*.*g*., bending, etc.) during handling by pick and place automation. Having the arms 164 attached to the sidewalls 116 in this exemplary manner at four different locations provides great stability, helps resists deformation of the frame 104 in the x and y lateral directions, and/or helps the bridge 108 remain attached to the frame 104 when carried by pick and place equipment. The arms 164 may also be configured to help maintain the side walls 116 in the generally rectangular shape of the frame 104 during such handling and installation to the PCB. In other exemplary embodiments, the arms 164 of the bridge 108 may extend from other locations of the sidewalls 116 and/or the arms 164 may extend directly across the frame 104 without using a central hub 160. Or, the bridge 108 may include more than or less than four arms 164 and/or arms in different orientations and/or arms attached to the sidewalls in more or less than four locations depending, for example, on the frame configuration (*e*.*g*., size, shape, mass, etc.).

Alternative embodiments may include a bridge having a different configuration, such as a pickup area with a different configuration (*e*.*g*., non-circular, offset from center, etc.) and/or differently configured arms (*e*.*g*., more or less than four, non-planar, non-flat, etc.) For example, another embodiment may include a bridge releasably attached to a frame where the bridge includes only two arms that extend outwardly from a pickup area to opposing sidewalls of the frame. In this example, the bridge extends between only the pair of opposing sidewalls and not all four sidewalls.

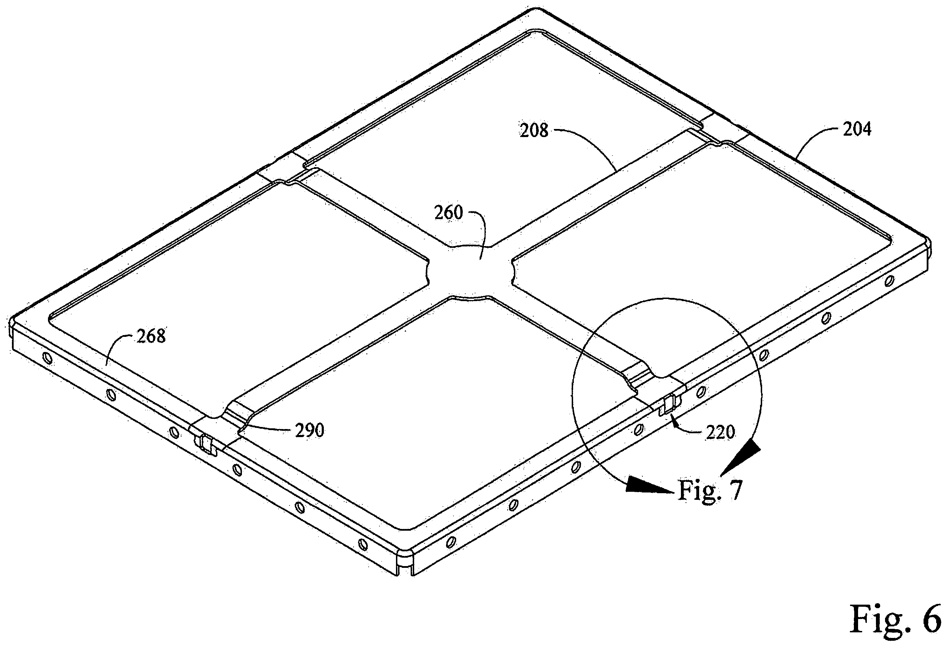

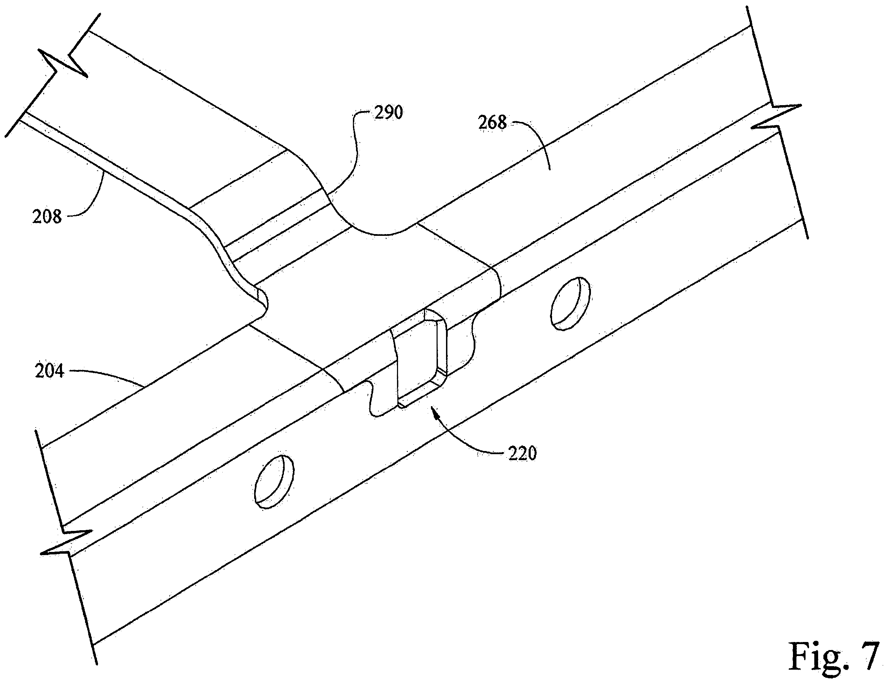

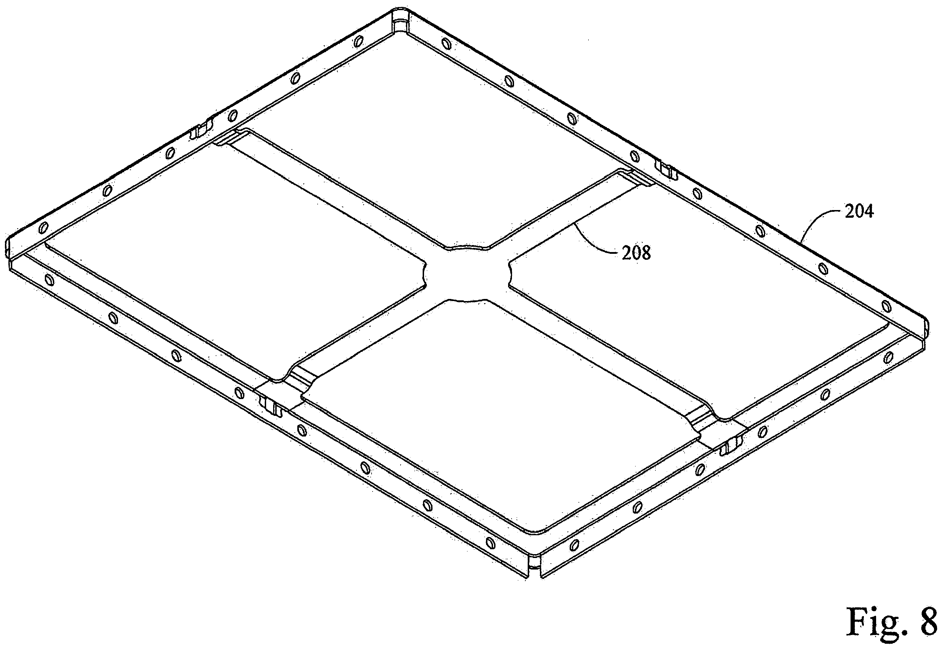

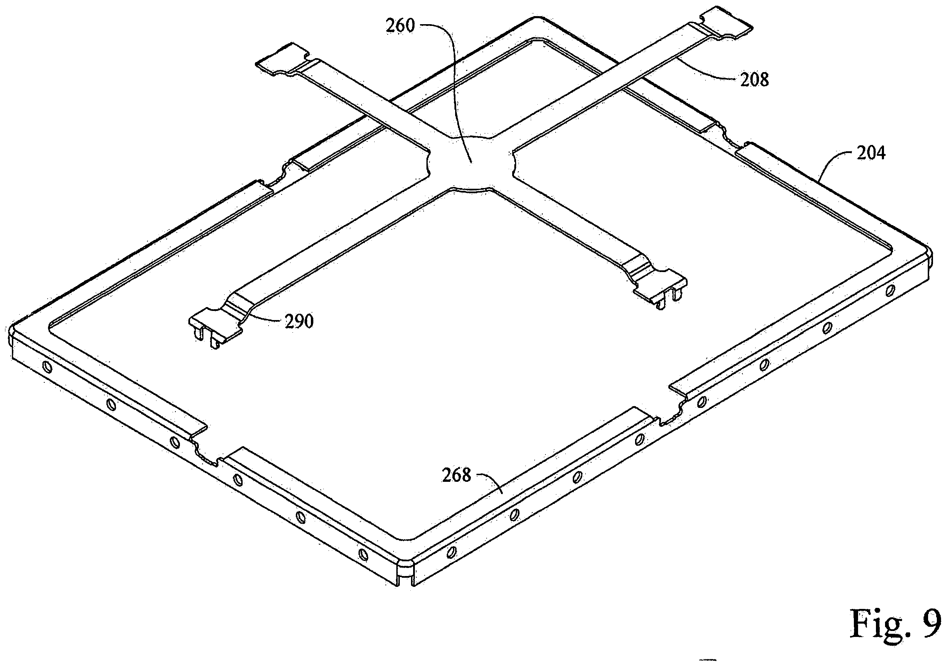

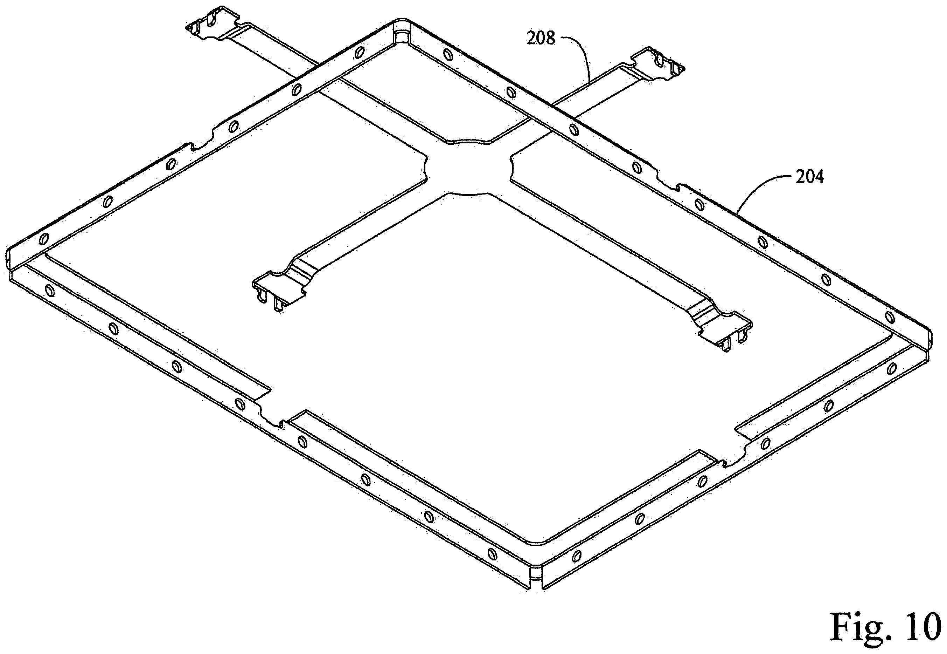

In this exemplary embodiment, the arms 164 and pickup area 160 are generally co-planar or aligned with the upper surface of the flange 168 of the frame 104. In alternative embodiments, a pickup bridge may be configured such that the pickup area and/or arms are not aligned and not co-planar (*e*.*g*., higher, lower, etc.) than an upper surface of the frame. For example, FIGS. 6 through 10 illustrate an exemplary embodiment of a bridge 208 configured such that its pickup area 260 is not co-planar but is raised or elevated above the upper surface of the frame's flange 268.

The bridge 108 and frame 104 may be formed from a single piece of electrically-conductive material (e.g., single blank of material, etc.) so that the frame's side walls 116 and bridge 108 have an integral, monolithic construction. A wide range of electrically-conductive materials may be used to form the bridge 108 and frame 104, such as those disclosed herein.

In one exemplary embodiment, a flat profile pattern for the frame 104 and bridge 108 may be stamped into a piece of material. The flat profile pattern may include the interlocking members 124, 128 and openings 144 that allow the bridge's interlocking members 124 to move inwardly. The flat profile pattern may also include mounting feet 176 for attaching the frame 104 to a PCB. At this point, the bridge 108 is releasably retained to the frame 104 by the frictional engagement of the interlocking members 124, 128 of the interlock 120. The frame's sidewalls 116 and interlock members 128 and the bridge's interlocking members 124 may then be formed, bent, drawn, shaped, folded, etc. into the configuration shown in FIGS. 1 through 5 (e.g., frame's sidewalls 116 and interlocking members 124, 128 generally perpendicular to the bridge 108, etc.).

In some exemplary embodiments, the bridge 108 and frame 104 may be formed by a combination of fabricating processes including drawing over a die, and then folding or bending part of the frame to produce the final desired shape. In such embodiments, the frame 104 may include corner sections having drawn portions and folded portions as disclosed in U.S. Patent 7,488,902. Additional embossing or crimping operations may be performed across the juncture or interface contact between the frame 104 and bridge 108 to help ensure retention of the frame 104 to the bridge 108, for example, during handling, packaging, pick & place operations, and/or customer installation/solder reflow, etc.

Even though the frame 104 and bridge 108 may be formed (e.g., stamping and bending/folding/drawing, etc.) from the same piece of material substantially simultaneously in this example, such is not required for all embodiments. For example, other embodiments may include one or more discrete components separately attached, for example, by welding, adhesives, among other suitable methods. Alternative configurations (*e*.*g*., shapes, sizes, etc.), materials, and manufacturing methods may be used for making the frame 104 and bridge 108.

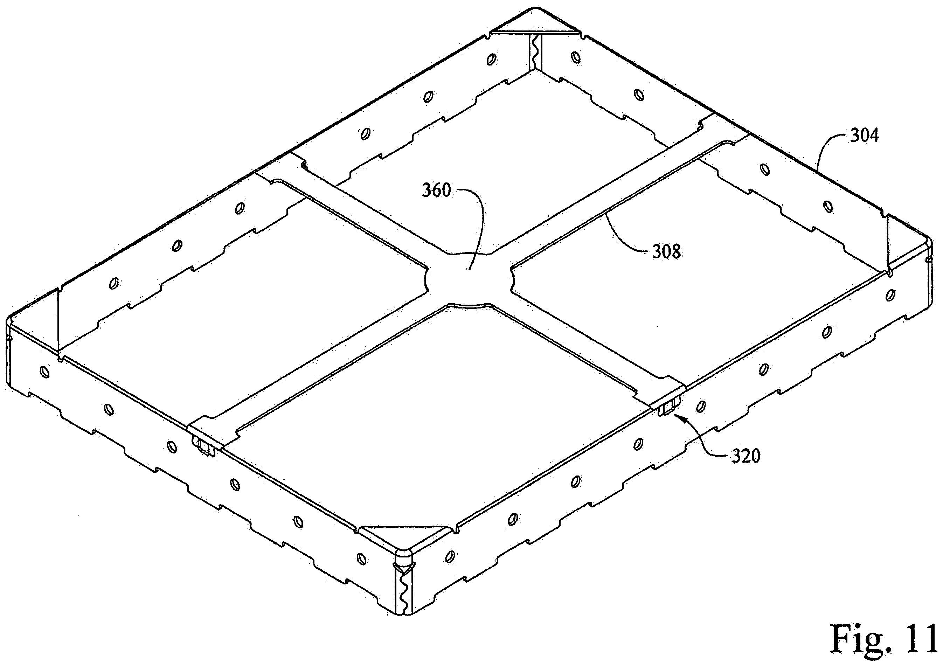

This illustrated frame 104 includes the inwardly extending rim, flange, or lip 168 defining the upper surface of the frame 104. But this frame configuration is but a mere example, as a bridge (*e*.*g*., 108, 208, 308, etc.) disclosed herein may be releasably attached to a frame having a different configuration. For example, FIG. 11 illustrate another exemplary embodiment in which a pickup bridge 308 is releasably attached to a frame 304 which does not include an inwardly extending lip, rim, or flange defining its upper surface.

With further regard to the frame 104, the four sidewalls 116 are arranged such that the frame 104 is generally rectangular in shape. In other exemplary embodiments, the frame 104 may include more than or fewer than four sidewalls 116 and/or sidewalls in a configuration different from that shown in the figures. For example, the sidewalls 116 may have a square configuration, a triangular configuration, a hexagonal configuration, another polygonal-shaped configuration, a circular configuration, a non-rectangular configuration, etc.

The frame 104 includes mounting feet 176 for contacting one or more components of the PCB to establish or provide for electrical contact with the PCB. The mounting feet 176 are formed as an integral part of the frame 104. While the mounting feet 176 may be soldered to the PCB, the frame 104 need not be soldered to a PCB in all embodiments. In one exemplary embodiment, the frame's mounting feet 176 may be soldered to grounding traces positioned on the PCB substrate and/or around the electrical circuits generating (or requiring protection from) electromagnetic interference as well as around the electrical circuits that are susceptible to interference. Alternative embodiments may include the frame 104 being installed (e.g., surface mounted, secured, etc.) to PCB by any acceptable means such as soldering, mechanical fastening, etc.

After the bridge 108 is removed or detached from the frame 104, the lid or cover 112 (FIGS. 1 and 2) may be positioned over the frame 104 to cover the open top of the frame 104. At which point, the cover 112 and the frame 104 may thus enclose the desired electrical components on the PCB and provide EMI shielding thereto.

In this illustrated embodiment, the cover 112 is releasably attached to the frame 102 by moving the cover 112 relatively downward onto the frame 104 to engage protuberances 180 (e.g., dimples, etc.) in the cover's sides 186 within corresponding openings 188 (e.g., thru-holes, etc.) in the frame's sidewalls 116. Accordingly, the cover 112 may thus be releasably secured to the frame 104 in this exemplary manner that permits the cover 112 to be fairly easily removed from and subsequently reattached to the frame 104.

The dimple/hole attachment of the cover 112 to the frame 104 is but a mere example, as other embodiments may include other means for retaining a cover to a frame. In another exemplary embodiment, the cover 112 may include interlocking members similar or identical to the interlocking members 124 of the bridge 108. Other exemplary embodiments may include the frame's side walls having protuberances (*e*.*g*., dimples, catches, snaps, latches, tabs, detents, protuberances, protrusions, ribs, ridges, ramp-ups, darts, lances, half-dimples, combinations thereof, etc.) that are configured to align with and be retained by corresponding openings (*e*.*g*., recesses, voids, cavities, slots, grooves, thru-holes, depressions, combinations thereof, etc.) formed in the sides of the cover. In other embodiments, the frame's side walls may comprise one or more retaining openings configured to align with and engagingly receive one or more protuberances formed in the sides of the lid. In still other embodiments, the frame's side walls may include one or more retaining apertures and one or more protuberances. Alternatively, other means can be employed for attaching the lid to the frame besides the engagement of protuberances within openings. In addition, alternative embodiments may also include a cover that is positioned over the frame without removing the releasably attached bridge.

The lid or cover 112 may include apertures or holes (not shown), which help with cooling of the electrical components within the shield 100 and/or permit visual inspection of members of the electrical components beneath the shield 100. In some exemplary embodiments, the lid or cover may include holes that are sufficiently small to inhibit passage of interfering EMI. The particular number, size, shape, orientation, etc. of the holes may vary depending, for example, on the particular application (*e*.*g*., sensitivity of the electronics where more sensitive circuitry may necessitate the use of smaller diameter holes, etc.). For example, some exemplary shields may include covers without any such holes.

In this example, the cover 112 is made (e.g., via stamping and then bending/folding/drawing, etc.) from a different piece than the material from which the frame 104 and bridge 108 are integrally formed. Alternatively, the cover 112 may be stamped and formed out of the same piece of material as the frame 104 and bridge 108.

FIGS. 6 through 10 illustrate another exemplary embodiment of a pickup bridge 208 and a frame 204 embodying one or more aspects of the present disclosure. As shown in FIG. 6, the pickup bridge 208 is releasably attached to the frame 204 by an interlock 220 in a similar manner as the interlock 120 by which the pickup bridge 108 is releasably attached to the frame 104.

In this example embodiment, the pickup bridge 208 includes end bent or upwardly angled portions 290 such that the pickup area 260 is higher than the upper surface of the frame's flange 268. Accordingly, the pickup area 260 of the bridge 208 is not co-planar or aligned with the frame's flange 268. In addition, the raised or elevated pickup area 260 also provides greater clearance for electronic components. With the greater clearance, the frame 204 and pickup bridge 208 may thus be placed over taller electronic components without those taller components contacting the pickup area 260.

FIG. 11 illustrates another exemplary embodiment of a pickup bridge 308 and a frame 304 embodying one or more aspects of the present disclosure. As shown in FIG. 11, the pickup bridge 308 is releasably attached to the frame 304 in a similar manner as the interlock 120 by which the pickup bridge 108 is releasably attached to the frame 104. The pickup bridge 308 also includes a pickup area 360, which is planar and/or generally aligned with the top surface edge of the frame 304.

In this example embodiment, however, the frame 304 does not include an inwardly extending lip, rim, or flange as do the frames 104, 204 which have flanges 168, 268, respectively. This flangeless construction of the frame 304 may thus provide greater access to the components within the footprint of the frame as there is no inwardly extending flange, which might otherwise obscure or impede access.

Further aspects of the present disclosure relate to methods of providing EMI shielding and installing an EMI shielding apparatus to a substrate. For example, a method will now be described for installing an electromagnetic interference (EMI) shielding apparatus (e.g., 100, etc.) to a substrate. In this example embodiment, the method generally includes placing a frame (e.g., 104, 204, 304, etc.) and releasably attached bridge (*e*.*g*., 108, 208, 308, etc.) on a PCB by using pick and place equipment. This may be accomplished by a suction nozzle applying suction to or a gripper grabbing a pickup area (*e*.*g*., 160, 260, 360, etc.) of the bridge. After the frame and bridge are placed on the PCB, the frame may then be coupled or attached to the PCB, such as by soldering, mechanical fastening, etc. In one example, mounting feet (*e*.*g*., 176, etc.) of the frame are soldered to traces on grounding traces positioned on the PCB substrate and/or around the electrical circuits generating (or requiring protection from) electromagnetic interference as well as around the electrical circuits that are susceptible to interference.

With the frame sufficiently attached to the PCB, the bridge may then be removed or detached from the frame. This may be accomplished by applying sufficient separation force to the bridge in a direction generally away from the PCB and frame, in order to disengage the interlock (*e*.*g*., 120, 220, 320, etc.) releasably attaching the bridge to the frame. This may be done manually or via an automated method, such as with pick and place equipment. For example, the bridge may be removed from the frame by a suction nozzle applying sufficient suction to the bridge's pickup area and then lifting the nozzle upward away from the frame to lift the bridge off the frame, which remains soldered to the PCB. Or, for example, a gripper may grab the bridge's pickup area and apply sufficient upward force to lift the bridge off the frame, again while the frame remains soldered to the PCB. The gripper and/or nozzle may be the same equipment used to place the frame on the PCB, or they may be different equipment.

With the bridge removed, post solder flow operations may occur, such as inspection of and access to the PCB components within the footprint of the frame. A cover or lid (*e.g.,* 116) may then be releasably attached to the frame via manual or automated methods (*e*.*g*., by pick and place equipment, etc.). The equipment used to place the frame on the PCB and/or remove the bridge may be used to place the cover on the frame, or different equipment may be used.

A non-exhaustive list will now be provided of exemplary materials from which may be made any one or more of the frames, bridges, and covers disclosed herein. Exemplary materials include cold rolled steel, nickel-silver alloys, copper-nickel alloys, stainless steel, tin-plated cold rolled steel, tin-plated copper alloys, carbon steel, brass, copper, aluminum, copper-beryllium alloys, phosphor bronze, steel, alloys thereof, a plastic material coated with electrically-conductive material, or any other suitable electrically-conductive and/or magnetic materials. The materials provided herein are for purposes of illustration only, as different materials may be used depending, for example, on the particular application, such as the components to be shielded, space considerations within the overall device, EMI shielding and heat dissipation needs, and other factors.

Numerical dimensions and values are provided herein for illustrative purposes only. The particular dimensions and values provided are not intended to limit the scope of the present disclosure.

Spatially relative terms, such as "inner," "outer," "beneath", "below", "lower", "above", "upper" and the like, may be used herein for ease of description to describe one element or feature's relationship to another element(s) or feature(s) as illustrated in the figures. Spatially relative terms may be intended to encompass different orientations of the device in use or operation in addition to the orientation depicted in the figures. For example, if the device in the figures is turned over, elements described as "below" or "beneath" other elements or features would then be oriented "above" the other elements or features. Thus, the example term "below" can encompass both an orientation of above and below. The device may be otherwise oriented (rotated 90 degrees or at other orientations) and the spatially relative descriptors used herein interpreted accordingly.

The terminology used herein is for the purpose of describing particular example embodiments only and is not intended to be limiting. As used herein, the singular forms "a", "an" and "the" may be intended to include the plural forms as well, unless the context clearly indicates otherwise. The terms "comprises," "comprising," "including," and "having," are inclusive and therefore specify the presence of stated features, integers, steps, operations, elements, and/or components, but do not preclude the presence or addition of one or more other features, integers, steps, operations, elements, components, and/or groups thereof. The method steps, processes, and operations described herein are not to be construed as necessarily requiring their performance in the particular order discussed or illustrated, unless specifically identified as an order of performance. It is also to be understood that additional or alternative steps may be employed.

When an element or layer is referred to as being "on", "engaged to", "connected to" or "coupled to" another element or layer, it may be directly on, engaged, connected or coupled to the other element or layer, or intervening elements or layers may be present. In contrast, when an element is referred to as being "directly on," "directly engaged to", "directly connected to" or "directly coupled to" another element or layer, there may be no intervening elements or layers present. Other words used to describe the relationship between elements should be interpreted in a like fashion (*e*.*g*., "between" versus "directly between," "adjacent" versus "directly adjacent," etc.). As used herein, the term "and/or" includes any and all combinations of one or more of the associated listed items.

Although the terms first, second, third, etc. may be used herein to describe various elements, components, regions, layers and/or sections, these elements, components, regions, layers and/or sections should not be limited by these terms. These terms may be only used to distinguish one element, component, region, layer or section from another region, layer or section. Terms such as "first," "second," and other numerical terms when used herein do not imply a sequence or order unless clearly indicated by the context. Thus, a first element, component, region, layer or section discussed below could be termed a second element, component, region, layer or section without departing from the teachings of the example embodiments.

Example embodiments are provided so that this disclosure will be thorough, and will fully convey the scope to those who are skilled in the art. Numerous specific details are set forth such as examples of specific components, devices, and methods, to provide a thorough understanding of embodiments of the present disclosure. It will be apparent to those skilled in the art that specific details need not be employed, that example embodiments may be embodied in many different forms and that neither should be construed to limit the scope of the disclosure. In some example embodiments, well-known processes, well-known device structures, and well-known technologies are not described in detail.

The disclosure herein of particular values and particular ranges of values for given parameters are not exclusive of other values and ranges of values that may be useful in one or more of the examples disclosed herein. Moreover, it is envisioned that any two particular values for a specific parameter stated herein may define the endpoints of a range of values that may be suitable for the given parameter. The disclosure of a first value and a second value for a given parameter can be interpreted as disclosing that any value between the first and second values could also be employed for the given parameter. Similarly, it is envisioned that disclosure of two or more ranges of values for a parameter (whether such ranges are nested, overlapping or distinct) subsume all possible combination of ranges for the value that might be claimed using endpoints of the disclosed ranges.

The foregoing description of the embodiments has been provided for purposes of illustration and description. It is not intended to be exhaustive or to limit the invention. Individual elements or features of a particular embodiment are generally not limited to that particular embodiment, but, where applicable, are interchangeable and can be used in a selected embodiment, even if not specifically shown or described. The same may also be varied in many ways. Such variations are not to be regarded as a departure from the invention, and all such modifications are intended to be included within the scope of the invention.

## Claims

1. A shielding apparatus (100) comprising:
a frame (104, 204, 304) configured for installation to a substrate generally about one or more components on the substrate; and
a pickup member (108, 208, 308) configured to allow the frame (104, 204, 304) and the pickup member (108, 208, 308) to be picked up by the pickup member (108, 208, 308) and placed on the substrate; the pickup member (108, 208, 308) being releasably attached to the frame (104, 204, 304) so that the pickup member (108, 208, 308) is detachable and completely separable from the frame (104, 204, 304) after the frame (104, 204, 304) is installed on the substrate so that the frame (104, 204, 304) remains installed on the substrate without the pickup member (108, 208, 308);
wherein the pickup member (108, 208, 308) and the frame (104, 204, 304) are integrally formed substantially simultaneously from a single piece of material.

2. The shielding apparatus (100) of the preceding claim, wherein the releasable attachment of the pickup member (108, 208, 308) and the frame (104, 204, 304) is within the footprint of the frame (104, 204, 304).

3. The shielding apparatus (100) of any one of the preceding claims, wherein an interface is formed between the pickup member (108, 208, 308) and the frame (104, 204, 304) such that the pickup member (108, 208, 308) is a detachable and completely separable part from the frame (104, 204, 304).

4. The shielding apparatus (100) of any one of the preceding claims, wherein the pickup member (108, 208, 308) includes:
a generally flat pickup area (160, 260, 360) configured to enable the pickup member (108, 208, 308), and frame (104, 204, 304) releasably attached thereto, to be picked up by a suction nozzle or gripper associated with pick-and-place equipment; and
arms (164) extending outwardly from the pickup area (160, 260, 360) and releasably attached to corresponding sidewalls (116) of the frame (104, 204, 304), such that the pickup member (108, 208, 308) spans across an open top of the frame (104, 204, 304), the arms (164) including bent or upwardly angled end portions (290) such that the pickup member (108, 208, 308) is higher than the frame (104, 204, 304), thereby providing greater clearance to electronic components which greater clearance allows the frame (104, 204, 304) and the pickup member (108, 208, 308) to be placed over taller electronic components without the taller components contacting the pickup area (160, 260, 360).

5. The shielding apparatus (100) of any one of the preceding claims, further comprising a cover (112) attachable to the frame (104, 204, 304), wherein the frame (104, 204, 304) has a flangeless construction, whereby the shielding apparatus (100) is operable for shielding the one or more components on the substrate that are within an interior cooperatively defined by the frame (104, 204, 304) and the cover (112).

6. The shielding apparatus (100) of any one of the preceding claims, wherein the pickup member (108, 208, 308) is configured to allow the pickup member (108, 208, 308) and the frame (104, 204, 304) to be picked up with pick-and-place equipment, and to allow the pickup member (108, 208, 308) to be detached and completely separated from the frame (104, 204, 304) using pick-and-place after the frame (104, 204, 304) is installed to the substrate.

7. The shielding apparatus (100) of any one of the preceding claims, wherein:
the frame (104, 204, 304) includes an inwardly extending flange (168, 268) defining at least one opening along an upper portion of the frame (104, 204, 304); and
an upper surface of the pickup member (108, 208, 308) is coplanar with the flange (168, 268) of the frame (104, 204, 304).

8. The shielding apparatus (100) of any one of the preceding claims, wherein the pickup member (108, 208, 308) is releasably attached to the frame (104, 204, 304) by an interlock (120, 220, 320) comprising:
a first interlocking member (124) integrally defined by the pickup member (108, 208, 308), and downwardly depending relative to an upper surface of the pickup member (108, 208, 308);
a second interlocking member (128) integrally defined by the frame (104, 204, 304), and upwardly protruding relative to the first interlocking member (124); and
an opening (144) to accommodate movement of the first interlocking member (124) inwardly relative to the opening (144), thereby allowing continued upward movement of the first interlocking member (124) relative to the second interlocking member (128) for disengaging the interlock (120, 220, 320).

9. The shielding apparatus (100) of claim 8, wherein:
the first interlocking member (124) comprises a pair of interlocking members configured for movement inwardly into the opening (144) generally towards each other while remaining substantially within the same plane as at least one sidewall (116) of the frame (104, 204, 304) integrally defining the second interlocking member (128); and/or
the first (124) and second (128) interlocking members do not extend outwardly beyond the plane of the at least one sidewall (116) integrally defining the second interlocking member (128) when the pickup member (108, 208, 308) is releasably attached to the frame (104, 204, 304).

10. The shielding apparatus (100) of claim 8 or 9, wherein:
the first interlocking member (124) comprises a protrusion (132) having a tapered surface portion (136), and the second interlocking member (128) comprises a cutout complementary in shape to the tapered surface portion (136) of the first interlocking member (124), such that the interlocking engagement of the cutout and the tapered surface portion (136) helps releasably retain the pickup member (108, 208, 308) to the frame (104, 204, 304); and/or
the second interlocking member (128) includes a camming surface (152) such that contact with the first interlocking member (124) causes inward movement of the first interlocking member (124) into the opening (144).

11. The shielding apparatus (100) of any one of claims 1 to 9, wherein the pickup member (108, 208, 308) is releasably attached to the frame (104, 204, 304) by an interlock (120, 220, 320), and wherein the interlock (120, 220, 320) is configured such that the interlock (120, 220, 320) is releasable by moving the pickup member (108, 208, 308) relatively away from the frame (104, 204, 304).

12. The shielding apparatus (100) of any one of claims 1 to 9, wherein:
the frame (104, 204, 304) includes sidewalls (116); and
the shielding apparatus (100) further comprises an interlock (120, 220, 320) integrally defined by the frame (104, 204, 304) and pickup member (108, 208, 308) and releasably attaching the pickup member (108, 208, 308) to the frame (104, 204, 304), the pickup member (108, 208, 308) extending between at least a pair of the sidewalls (116) of the frame (104, 204, 304) when releasably attached to the frame (104, 204, 304) by the interlock (120, 220, 320), the pickup member (108, 208, 308) detachable and completely separable from the frame (104, 204, 304) upon disengagement of the interlock (120, 220, 320).

13. The shielding apparatus (100) of any one of claims 10 to 12, wherein:
the interlock (120, 220, 320) is configured such that the interlock (120, 220, 320) is releasable by moving the pickup member (108, 208, 308) relatively away from the frame (104, 204, 304); and/or
the pickup member (108, 208, 308) is detachable from the frame (104, 204, 304) by moving the pickup member (108, 208, 308) relatively away from the frame (104, 204, 304) using pick-and-place equipment without requiring any cutting of the frame (104, 204, 304) or pickup member (108, 208, 308) and without deforming the frame (104, 204, 304); and/or
the interlock (120, 220, 320) is within the footprint of the frame (104, 204, 304).

## Patentansprüche

1. Abschirmungsvorrichtung (100), die Folgendes umfasst:
einen Rahmen (104, 204, 304), das für eine Montage auf einem Substrat allgemein um eine oder mehrere Komponenten auf dem Substrat herum konfiguriert ist; und
ein Aufnahmeelement (108, 208, 308), das dafür konfiguriert ist, es dem Rahmen (104, 204, 304) und dem Aufnahmeelement (108, 208, 308) zu ermöglichen, durch das Aufnahmeelement (108, 208, 308) aufgenommen und auf das Substrat gelegt werden; wobei das Aufnahmeelement (108, 208, 308) lösbar so an dem Rahmen (104, 204, 304) angebracht ist, dass das Aufnahmeelement (108, 208, 308) abnehmbar ist und vollständig von dem Rahmen (104, 204, 304) abgetrennt werden kann, nachdem der Rahmen (104, 204, 304) auf dem Substrat montiert wurde, so dass der Rahmen (104, 204, 304) ohne das Aufnahmeelement (108, 208, 308) auf dem Substrat montiert bleibt;
wobei das Aufnahmeelement (108, 208, 308) und der Rahmen (104, 204, 304) integral im Wesentlichen gleichzeitig aus einem einzelnen Stück Material gebildet werden.

2. Abschirmungsvorrichtung (100) nach dem vorangehenden Anspruch, wobei die lösbare Anbringung des Aufnahmeelements (108, 208, 308) und des Rahmens (104, 204, 304) innerhalb der Auflagefläche des Rahmens (104, 204, 304) liegt.

3. Abschirmungsvorrichtung (100) nach einem der vorangehenden Ansprüche, wobei eine Schnittstelle zwischen dem Aufnahmeelement (108, 208, 308) und dem Rahmen (104, 204, 304) ausgebildet ist, dergestalt, dass das Aufnahmeelement (108, 208, 308) ein abnehmbares und vollständig von dem Rahmen (104, 204, 304) abtrennbares Teil ist.

4. Abschirmungsvorrichtung (100) nach einem der vorangehenden Ansprüche, wobei das Aufnahmeelement (108, 208, 308) Folgendes enthält:
einen allgemein flachen Aufnahmebereich (160, 260, 360), der dafür konfiguriert ist, es zu ermöglichen, dass das Aufnahmeelement (108, 208, 308) und der daran lösbar angebrachte Rahmen (104, 204, 304) durch eine Saugdüse oder einen Greifer einer Aufnahme-und-Ablege-Ausrüstung aufgenommen werden; und
Arme (164), die sich von dem Aufnahmebereich (160, 260, 360) nach außen erstrecken und lösbar an entsprechenden Seitenwänden (116) des Rahmens (104, 204, 304) angebracht sind, dergestalt, dass sich das Aufnahmeelement (108, 208, 308) über eine offene Oberseite des Rahmens (104, 204, 304) spannt, wobei die Arme (164) gebogene oder aufwärts gewinkelte Endabschnitte (290) enthalten, dergestalt, dass das Aufnahmeelement (108, 208, 308) höher als der Rahmen (104, 204, 304) ist, wodurch ein größerer Freiraum für elektronische Komponenten erhalten wird, wobei der größere Freiraum es dem Rahmen (104, 204, 304) und dem Aufnahmeelement (108, 208, 308) erlaubt, über höheren elektronischen Komponenten angeordnet zu werden, ohne dass die höheren Komponenten den Aufnahmebereich (160, 260, 360) berühren.

5. Abschirmungsvorrichtung (100) nach einem der vorangehenden Ansprüche, die des Weiteren eine Abdeckung (112) umfasst, die an dem Rahmen (104, 204, 304) angebracht werden kann, wobei der Rahmen (104, 204, 304) einen flanschlosen Aufbau hat, wobei die Abschirmungsvorrichtung (100) dafür geeignet ist, die eine oder die mehreren Komponenten auf dem Substrat abzuschirmen, die sich in einem Innenraum befinden, der durch den Rahmen (104, 204, 304) und die Abdeckung (112) gemeinsam gebildet wird.

6. Abschirmungsvorrichtung (100) nach einem der vorangehenden Ansprüche, wobei das Aufnahmeelement (108, 208, 308) dafür konfiguriert ist, es dem Aufnahmeelement (108, 208, 308) und dem Rahmen (104, 204, 304) zu erlauben, mit einer Aufnahme-und-Ablege-Ausrüstung aufgenommen zu werden, und es dem Aufnahmeelement (108, 208, 308) zu erlauben, mittels Aufnehmen und Ablegen abgenommen und vollständig von dem Rahmen (104, 204, 304) getrennt zu werden, nachdem der Rahmen (104, 204, 304) an dem Substrat montiert wurde.

7. Abschirmungsvorrichtung (100) nach einem der vorangehenden Ansprüche, wobei:
der Rahmen (104, 204, 304) einen sich nach innen erstreckenden Flansch (168, 268) enthält, der mindestens eine Öffnung entlang eines oberen Abschnitts des Rahmens (104, 204, 304) definiert; und
eine Oberseite des Aufnahmeelements (108, 208, 308) mit dem Flansch (168, 268) des Rahmens (104, 204, 304) koplanar ist.

8. Abschirmungsvorrichtung (100) nach einem der vorangehenden Ansprüche, wobei das Aufnahmeelement (108, 208, 308) lösbar an dem Rahmen (104, 204, 304) durch eine Verriegelung (120, 220, 320) angebracht ist, die Folgendes umfasst:
ein erstes Verriegelungselement (124), das integral durch das Aufnahmeelement (108, 208, 308) definiert wird und relativ zu einer Oberseite des Aufnahmeelements (108, 208, 308) nach unten ragt;
ein zweites Verriegelungselement (128), das integral durch den Rahmen (104, 204, 304) definiert wird und relativ zu dem ersten Verriegelungselement (124) nach oben ragt; und
eine Öffnung (144) zu Aufnehmen einer Bewegung des ersten Verriegelungselements (124) nach innen relativ zu der Öffnung (144), wodurch eine fortgesetzte Aufwärtsbewegung des ersten Verriegelungselements (124) relativ zu dem zweiten Verriegelungselement (128) ermöglicht wird, um die Verriegelung (120, 220, 320) zu lösen.

9. Abschirmungsvorrichtung (100) nach Anspruch 8, wobei:
das erste Verriegelungselement (124) ein Paar Verriegelungselemente umfasst, die dafür konfiguriert sind, eine Bewegung nach innen in die Öffnung (144) allgemein in Richtung aufeinander auszuführen, während die im Wesentlichen innerhalb derselben Ebene bleiben wie mindestens eine Seitenwand (116) des Rahmens (104, 204, 304), der integral das zweite Verriegelungselement (128) definiert; und/oder
das erste (124) und das zweite (128) Verriegelungselement sich nicht nach außen über die Ebene der mindestens einen Seitenwand (116) hinaus erstrecken, die integral das zweite Verriegelungselement (128) definiert, wenn das Aufnahmeelement (108, 208, 308) lösbar an dem Rahmen (104, 204, 304) angebracht ist.

10. Abschirmungsvorrichtung (100) nach Anspruch 8 oder 9, wobei:
das erste Verriegelungselement (124) einen Vorsprung (132) umfasst, der einen verjüngten Oberflächenabschnitt (136) aufweist, und das zweite Verriegelungselement (128) einen Ausschnitt umfasst, dessen Form komplementär zu der des verjüngten Oberflächenabschnitts (136) des ersten Verriegelungselements (124) ist, dergestalt, dass der Verriegelungseingriff des Ausschnitts und des verjüngten Oberflächenabschnitts (136) hilft, das Aufnahmeelement (108, 208, 308) lösbar an dem Rahmen (104, 204, 304) zu halten; und/oder
das zweite Verriegelungselement (128) eine Nockenfläche (152) enthält, dergestalt, dass der Kontakt mit dem ersten Verriegelungselement (124) eine Einwärtsbewegung des ersten Verriegelungselements (124) in die Öffnung (144) hinein bewirkt.

11. Abschirmungsvorrichtung (100) nach einem der Ansprüche 1 bis 9, wobei das Aufnahmeelement (108, 208, 308) lösbar an dem Rahmen (104, 204, 304) durch eine Verriegelung (120, 220, 320) angebracht ist, und wobei die Verriegelung (120, 220, 320) so konfiguriert ist, dass die Verriegelung (120, 220, 320) lösbar ist, indem das Aufnahmeelement (108, 208, 308) relativ von dem Rahmen (104, 204, 304) fortbewegt wird.

12. Abschirmungsvorrichtung (100) nach einem der Ansprüche 1 bis 9, wobei:
der Rahmen (104, 204, 304) Seitenwände (116) enthält; und
die Abschirmungsvorrichtung (100) des Weiteren eine Verriegelung (120, 220, 320) umfasst, die integral durch den Rahmen (104, 204, 304) und das Aufnahmeelement (108, 208, 308) definiert wird und das Aufnahmeelement (108, 208, 308) lösbar an dem Rahmen (104, 204, 304) befestigt, wobei sich das Aufnahmeelement (108, 208, 308) zwischen mindestens einem Paar der Seitenwände (116) des Rahmens (104, 204, 304) erstreckt, wenn es lösbar an dem Rahmen (104, 204, 304) durch die Verriegelung (120, 220, 320) angebracht ist, wobei das Aufnahmeelement (108, 208, 308) beim Lösen der Verriegelung (120, 220, 320) abgenommen und vollständig von dem Rahmen (104, 204, 304) getrennt werden kann.

13. Abschirmungsvorrichtung (100) nach einem der Ansprüche 10 bis 12, wobei:
die Verriegelung (120, 220, 320) so konfiguriert ist, dass die Verriegelung (120, 220, 320) gelöst werden kann, indem das Aufnahmeelement (108, 208, 308) relativ von dem Rahmen (104, 204, 304) fort bewegt wird; und/oder
das Aufnahmeelement (108, 208, 308) von dem Rahmen (104, 204, 304) abgenommen werden kann, indem das Aufnahmeelement (108, 208, 308) unter Verwendung der Aufnahme-und-Ablege-Ausrüstung relativ von dem Rahmen (104, 204, 304) fort bewegt wird, ohne dass ein Schneiden des Rahmens (104, 204, 304) oder des Aufnahmeelements (108, 208, 308) erforderlich ist und ohne den Rahmen (104, 204, 304) zu verformen; und/oder die Verriegelung (120, 220, 320) innerhalb der Auflagefläche des Rahmens (104, 204, 304) liegt.

## Revendications

1. Appareil de protection (100) comprenant :
un cadre (104, 204, 304) configuré pour une installation sur un substrat généralement autour d'un ou plusieurs composants sur le substrat ; et
un organe de prise (108, 208, 308) configuré pour permettre au cadre (104, 204, 304) et à l'organe de prise (108, 208, 308) d'être pris par l'organe de prise (108, 208, 308) et placés sur le substrat ; l'organe de prise (108, 208, 308) étant attaché, de manière libérable, au cadre (104, 204, 304) de sorte que l'organe de prise (108, 208, 308) soit détachable et complètement séparable du cadre (104, 204, 304) après l'installation du cadre (104, 204, 304) sur le substrat de sorte que le cadre (104, 204, 304) reste installé sur le substrat sans l'organe de prise (108, 208, 308) ;
dans lequel l'organe de prise (108, 208, 308) et le cadre (104, 204, 304) sont formés intégralement sensiblement simultanément d'un morceau unique de matériau.

2. Appareil de protection (100) selon la revendication précédente, dans lequel l'attachement libérable de l'organe de prise (108, 208, 308) et du cadre (104, 204, 304) est à l'intérieur de l'empreinte du cadre (104, 204, 304).

3. Appareil de protection (100) selon l'une quelconque des revendications précédentes, dans lequel il est formé une interface entre l'organe de prise (108, 208, 308) et le cadre (104, 204, 304) de sorte que l'organe de prise (108, 208, 308) soit une partie détachable et complètement séparable du cadre (104, 204, 304).

4. Appareil de protection (100) selon l'une quelconque des revendications précédentes, dans lequel l'organe de prise (108, 208, 308) comprend :
une zone de prise généralement plate (160, 260, 360) configurée pour permettre à l'organe de prise (108, 208, 308) et au cadre (104, 204, 304) attaché, de manière libérable, à celui-ci, d'être pris par une buse d'aspiration ou un dispositif de préhension associé à l'équipement de prise et de placement ; et
des bras (164) s'étendant vers l'extérieur depuis la zone de prise (160, 260, 360) et attachés, de manière libérable, à des parois latérales correspondantes (116) du cadre (104, 204, 304), de sorte que l'organe de prise (108, 208, 308) recouvre un sommet ouvert du cadre (104, 204, 304), les bras (164) comprenant des portions d'extrémité pliées inclinées vers le haut (290) de sorte que l'organe de prise (108, 208, 308) soit plus haut que le cadre (104, 204, 304), en fournissant de ce fait un plus grand espace libre aux composants électroniques, le plus grand espace libre permettant au cadre (104, 204, 304) et à l'organe de prise (108, 208, 308) d'être placés au-dessus de composants électroniques plus grands sans que les composants plus grands ne touchent la zone de prise (160, 260, 360).

5. Appareil de protection (100) selon l'une quelconque des revendications précédentes, comprenant en outre un couvercle (112) attachable au cadre (104, 204, 304), dans lequel le cadre (104, 204, 304) a une construction sans bride, de telle manière que l'appareil de protection (100) soit utilisable pour protéger l'un ou plusieurs composants sur le substrat se trouvant dans un intérieur défini, en coopération, par le cadre (104, 204, 304) et le couvercle (112).

6. Appareil de protection (100) selon l'une quelconque des revendications précédentes, dans lequel l'organe de prise (108, 208, 308) est configuré pour permettre à l'organe de prise (108, 208, 308) et au cadre (104, 204, 304) d'être pris avec un équipement de prise et de placement, et pour permettre à l'organe de prise (108, 208, 308) d'être détaché et complètement séparé du cadre (104, 204, 304) en utilisant l'équipement de prise et de placement après l'installation du cadre (104, 204, 304) sur le substrat.

7. Appareil de protection (100) selon l'une quelconque des revendications précédentes, dans lequel :
le cadre (104, 204, 304) comprend une bride s'étendant vers l'intérieur (168, 268) définissant au moins une ouverture le long d'une portion supérieure du cadre (104, 204, 304) ; et
une surface supérieure de l'organe de prise (108, 208, 308) est dans le même plan que la bride (168, 268) du cadre (104, 204, 304).

8. Appareil de protection (100) selon l'une quelconque des revendications précédentes, dans lequel l'organe de prise (108, 208, 308) est attaché, de manière libérable, au cadre (104, 204, 304) par un emboîtement (120, 220, 320) comprenant :
un premier organe d'emboîtement (124) défini intégralement par l'organe de prise (108, 208, 308) et faisant saillie vers le bas par rapport à une surface supérieure de l'organe de prise (108, 208, 308) ;
un deuxième organe d'emboîtement (128) défini intégralement par le cadre (104, 204, 304) et faisant saillie vers le haut par rapport au premier organe d'emboîtement (124) ; et
une ouverture (144) pour permettre le mouvement du premier organe d'emboîtement (124) vers l'intérieur par rapport à l'ouverture (144), en permettant de ce fait un mouvement continu vers le haut du premier organe d'emboîtement (124) par rapport au deuxième organe d'emboîtement (128) pour désengager l'emboîtement (120, 220, 320).

9. Appareil de protection (100) selon la revendication 8, dans lequel :
le premier organe d'emboîtement (124) comprend une paire d'organes d'emboîtement configurés pour se déplacer vers l'intérieur dans l'ouverture (144) généralement l'un vers l'autre tout en restant sensiblement dans le même plan qu'au moins une paroi latérale (116) du cadre (104, 204, 304) définissant intégralement le deuxième organe d'emboîtement (128) ; et/ou
le premier organe d'emboîtement (124) et le deuxième organe d'emboîtement (128) ne s'étendent pas vers l'extérieur au-delà du plan de l'au moins une paroi latérale (116) définissant intégralement le deuxième organe d'emboîtement (128) lorsque l'organe de prise (108, 208, 308) est attaché, de manière libérable, au cadre (104, 204, 304).

10. Appareil de protection (100) selon la revendication 8 ou 9, dans lequel :
le premier organe d'emboîtement (124) comprend une protubérance (132) ayant une portion de surface effilée (136), et le deuxième organe d'emboîtement (128) comprend une encoche de forme complémentaire à la forme de la portion de surface effilée (136) du premier organe d'emboîtement (124), de sorte que l'engagement d'emboîtement de l'encoche et de la portion de surface effilée (136) aide à retenir, de manière libérable, l'organe de prise (108, 208, 308) sur le cadre (104, 204, 304) ; et/ou
le deuxième organe d'emboîtement (128) comprend une surface de came (152) de sorte qu'un contact avec le premier organe d'emboîtement (124) provoque le déplacement vers l'intérieur du premier organe d'emboîtement (124) dans l'ouverture (144).

11. Appareil de protection (100) selon l'une quelconque des revendications 1 à 9, dans lequel l'organe de prise (108, 208, 308) est attaché, de manière libérable, au cadre (104, 204, 304) par un emboîtement (120, 220, 320), et dans lequel l'emboîtement (120, 220, 320) est configuré de sorte que l'emboîtement (120, 220, 320) soit libérable en éloignant relativement l'organe de prise (108, 208, 308) du cadre (104, 204, 304).

12. Appareil de protection (100) selon l'une quelconque des revendications 1 à 9, dans lequel :
le cadre (104, 204, 304) comprend des parois latérales (116) ; et
l'appareil de protection (100) comprend en outre un emboîtement (120, 220, 320) défini intégralement par le cadre (104, 204, 304) et l'organe de prise (108, 208, 308) et attachant, de manière libérable, l'organe de prise (108, 208, 308) au cadre (104, 204, 304), l'organe de prise (108, 208, 308) s'étendant entre au moins une paire des parois latérales (116) du cadre (104, 204, 304) lorsqu'il est attaché, de manière libérable, au cadre (104, 204, 304) par l'emboîtement (120, 220, 320), l'organe de prise (108, 208, 308) étant détachable et complètement séparable du cadre (104, 204, 304) lors du désengagement de l'emboîtement (120, 220, 320).

13. Appareil de protection (100) selon l'une quelconque des revendications 10 à 12, dans lequel :
l'emboîtement (120, 220, 320) est configuré de sorte que l'emboîtement (120, 220, 320) soit libérable en éloignant relativement l'organe de prise (108, 208, 308) du cadre (104, 204, 304) ; et/ou l'organe de prise (108, 208, 308) est détachable du cadre (104, 204, 304) en éloignant relativement l'organe de prise (108, 208, 308) du cadre (104, 204, 304) en utilisant un équipement de prise et de placement sans nécessiter de découpage du cadre (104, 204, 304) ou de l'organe de prise (108, 208, 308) et sans déformer le cadre (104, 204, 304) ; et/ou
l'emboîtement (120, 220, 320) est à l'intérieur de l'empreinte du cadre (104, 204, 304).
